# EUROPÄISCHE PATENTANMELDUNG

(11) **EP 2 154 724 A2**
(43) Veröffentlichungstag der Anmeldung: **17.02.2010**
(21) Anmeldenummer: 09009731.2
(22) Anmeldetag: 28.07.2009
(51) Int. Cl.: H01L 29/786, H01L 21/77, B41J 2/14, H01L 51/56, H01Q 17/00, H05B 33/12

(54) **Flexible flächige Struktur mit einer Mikrostrukturen aufweisenden Schicht, Verfahren zur Herstellung der flexiblen flächigen Struktur und deren Verwendung**

(30) Priorität: 05.08.2008 DE 102008036382; 18.09.2008 DE 102008047959
(71) Anmelder: Alcan Technology & Management Ltd., 8212 Neuhausen am Rheinfall (CH)
(72) Erfinder: Kiy, Michael, 8404 Winterthur (CH); Lohwasser, Wolfgang, 78262 Gailingen (DE); Clarinha, Silvia, 78224 Singen (DE)

(57) **Zusammenfassung**

Die Erfindung betrifft eine flexible flächige Struktur (1) aufweisend eine plastisch verformte, insbesondere gereckte, Substratfolie (2) und wenigstens eine Dünnschicht (3) auf der Substratfolie (2), welche Dünnschicht, insbesondere eine geringere Elastizität aufweist als die Substratfolie (2) und, in Flächenrichtung begrenzte Mikrostrukturen (5) bildet, wobei zur Erzeugung von die Mikrostrukturen (5) begrenzenden Unterbrechungen (4) die wenigstens eine Dünnschicht (3) zusammen mit der Substratfolie (2) plastisch verformt ist. Erfindungsgemäß ist vorgesehen, dass die Mikrostrukturen (5) als Funktionsmittel dienen. In einer besonders bevorzugten Weiterbildung dienen die Mikrostrukturen (5) als elektrisch aktives oder passives Funktionsmittel. In einer anderen bevorzugten Weiterbildung dienen die Mikrostrukturen (5) als Druckmittel.

## Beschreibung

Die Erfindung betrifft eine flexible flächige Struktur aufweisend eine plastisch verformte, insbesondere organische, Substratfolie und wenigstens eine, insbesondere anorganische, Dünnschicht auf der Substratfolie, welche eine geringere Elastizität aufweist als die Substratfolie und in Flächenrichtung begrenzte Mikrostrukturen bildet. Die Erfindung betrifft weiter ein Verfahren zur Herstellung einer solchen flexiblen flächigen Struktur. Weiter führt die Erfindung auf geeignete Verwendungen einer oder mehrerer der flexiblen flächigen Strukturen.

Für verschiedene elektrische Bauteile auf Folien ist es erforderlich, elektrisch leitende Schichten od. dgl. Mikrostrukturen zu strukturieren. Besonders herausfordernd ist dies im Fall von z.B. Dünnfilmtransistoren die z.B. als Polymer-Feldeffekt-Transistoren od. dgl. grundsätzlich bekannt sind. Problematisch ist dabei die Darstellung möglichst nah beieinanderliegender leitender Linienstrukturen, um eine Transistor-Kanalbreite - d.h. eine Strukturgröße - möglichst gering zu halten; die Strukturgröße ist ein wesentlicher Parameter für die Geschwindigkeit eines Transistors oder anderen dergleichen, insbesondere aktiven oder passiven, elektrischen Funktionsmittel.

Z. Zt. werden anorganische elektrische Strukturen mittels Fotolithographie, wie sie aus der Siliziumtechnologie bekannt ist, hergestellt. Damit sind inzwischen Strukturgrößen unterhalb von 50 nm erreichbar. Andere Technologien wie das Drucken von leitfähigen Pasten, Tinten od.dgl. sind auf Auflösungen beschränkt, die wesentlich größer sind, so z.B. beim Darstellen von Transistorkanalbreiten mit Inkjet-Technologie im Bereich von etwa 10 µm. Andere, obgleich schnellere, Verfahren wie Tief- oder Siebdruck liegen im Bereich von weiter verschlechterter Auflösung von maximal 50 µm.

Wünschenswert ist es, insbesondere im Hinblick auf Elektronikanwendungen oder Druckanwendungen, eine vergleichsweise schnelle und dennoch eine zu einer hohen Auflösung führende Technologie bereitzustellen.

Bisherige Ansätze von Y. Leterrier et al., wie sie in "Mechanical Properties of Transparent Functional Thin Fils for Flexible Displays" in 46th Annual Technical Conference Proceedings (2003), Seiten 196 bis 174 oder Erik Garnett et al. in "Electrical and Morphological Properties of Inkjet Printed PEDOT/PSS Films in US Department of Energy Journal of Undergraduate Research, Seiten 24 bis 29 (http://www.scied.science.doe.gov) beschrieben sind erweisen sich noch als verbesserungswürdig.

Insbesondere für die "Roll-to-Roll"-Herstellung von Elektronik oder Inkjet-Anwendungen der vorgenannten Art ist es erforderlich, eine flexible flächige Struktur und ein Herstellungsverfahren anzugeben, welches schnell und trotzdem hochauflösend ist. Insbesondere sollte das Herstellungsverfahren bzw. die flexible flächige Struktur besonders preiswert darstellbar sein.

An dieser Stelle setzt die Erfindung an, deren Aufgabe es ist, eine flexible flächige Struktur und ein Verfahren zu deren Herstellung und eine Verwendung anzugeben, die vergleichsweise schnell und mit vergleichsweise hoher Auflösung darstellbar sind.

Hinsichtlich der flexiblen flächigen Struktur wird die Aufgabe durch die Erfindung mittels einer flexiblen flächigen Struktur gemäß Anspruch 1 gelöst, wobei erfindungsgemäß die Mikrostrukturen als Funktionsmittel dienen.

Die Erfindung führt dementsprechend auf ein Verfahren der eingangs genannten Art gemäß Anspruch 18, wobei zur Erzeugung von die Mikrostrukturen begrenzenden Unterbrechungen die wenigstens eine Dünnschicht zusammen mit der Substratfolie plastisch verformt wird und wobei die Mikrostrukturen als Funktionsmittel ausgelegt werden.

Es hat sich als besonders vorteilhaft erwiesen, dass eine plastische Verformung durch einen Reckvorgang erfolgt. Im Grundsatz hat die Erfindung erkannt, dass sich eine mit einer vergleichsweise rissanfälligen Dünnschicht bedeckte plastisch verformbare Substratfolie im Rahmen eines für Substratfolie und Dünnschicht zusammen durchgeführten plastischen Verformungsverfahrens für die oben genannte Aufgabe vorteilhaft verhalten. So kann die Dünnschicht insbesondere eine geringere Elastizität und/oder Dicke als die Substratfolie aufweisen. Die Dünnschicht kann insbesondere spröder sein als die Substratfolie. Auch hat sich gezeigt, dass sich das Reißverhalten über die Haftung der Dünnschicht vorteilhaft einstellen lässt. Es hat sich herausgestellt, dass die Dünnschicht in eine Vielzahl kleiner Risse senkrecht zur Verformungsrichtung, insbesondere senkrecht zu einer Reckrichtung reißt. Insbesondere wurde überraschend festgestellt, dass bei plastischer Verformung, insbesondere bei Reckung, besonders feine Risse erzeugt werden, welche sich quer zur plastischen Verformungsrichtung, insbesondere quer zur Reckrichtung über große Bereiche der Substratfolie erstrecken.

Untersuchungen von mechanischen Eigenschaften in Barriere-Beschichtungen für Verpackungsmaterial finden sich bei Y. Leterrier in "Durability of Thin PECVD SiOx Coatings on Polymer Films", 41th Annual Technical Conference Proceedings (1998), Seiten 429 bis 433 und bei M. Yanaka in "Durability and Defect Distribution of SiOx Film on Polymer Substrate Analyzed by a Statistical Approach", 44th Annual Technical Conference Proceedings, Philadelphia, April 21-26, 2001, Seiten 487 bis 491. Gleichwohl werden die dort untersuchten Fragmentierungen als Störfaktor für die Barriere-Schichteigenschaften im Verpackungsmaterial erkannt.

Die konzeptionelle Leistung der vorliegenden Erfindung liegt in der Erkenntnis, dass Mikrostrukturen der beanspruchten Art vorteilhaft als Funktionsmittel ausgenutzt werden können, insbesondere als elektrisches, vorzugsweise aktives oder passives, Funktionsmittel oder als Druckmittel zum Einsatz beim Tinten(strahl)druck. Dies betrifft insbesondere Weiterbildungen, bei denen die Substratfolie aus organischem Material ist und/oder die Dünnschicht aus anorganischem Material ist.

Vorteilhafte Weiterbildungen der Erfindung sind den Unteransprüchen zu entnehmen und geben im Einzelnen vorteilhafte Möglichkeiten an, das oben erläuterte Konzept im Rahmen der Aufgabenstellung, sowie hinsichtlich weiterer Vorteile zu realisieren.

Eine erste Variante von Mikrostrukturen zeichnet sich dadurch aus, dass diese unidirektional durch Unterbrechungen begrenzt sind. Vorteilhaft sind flexible flächige Strukturen zur Erzeugung von nur unidirektional ausgerichteten Mikrostrukturen durch unidirektionales Recken der Substratfolie mit der wenigstens einen Dünnschicht hergestellt.

In einer zweiten Variante können bidirektional ausgerichtete Mikrostrukturen durch Unterbrechungen begrenzt sein. Flexible flächige Strukturen mit bidirektionalen durch Unterbrechungen begrenzten Mikrostrukturen lassen sich besonders vorteilhaft durch bidirektionales Recken der Substratfolie mit der wenigstens einen Dünnschicht herstellen.

Insgesamt kann grundsätzlich ein beliebiger Kunststoff als organisches Material für die Substratfolie zur Verfügung gestellt werden. Als besonders vorteilhaft hat sich ein aromatisches Polyester erwiesen, wie z.B. PET od.dgl. Als Dünnschichtmaterial eignet sich insbesondere ein anorganisches Material. Vorteilhaft für elektronische oder Druck-Anwendungen haben sich Oxidmaterialien wie SiOₓ oder Keramiken od.dgl. erwiesen. Für die vorgenannte Variante einer bevorzugten Verwendung der Mikrostrukturen als elektrisch aktives oder passives Funktionsmittel wird die Dünnschicht in bevorzugter Weise elektrisch leitfähig ausgelegt. Dazu kann die leitfähige Dünnschicht in besonders bevorzugter Weise aus Metall oder einem Indium-Zinn dotierten Oxid (ITO) oder einer keramischen Schicht mit elektrisch leitfähigen Partikeln gebildet sein.

Insbesondere zur Darstellung von aktiven Bauelementen mit elektrischer Funktion od.dgl. hat es sich als vorteilhaft erwiesen, die wenigstens eine Dünnschicht als Teil einer Dünnschichtstruktur auszulegen, welche eine Anzahl von weiteren Dünnschichten aufweist.

Je nach Bedarf und Komplexität des darzustellenden Bauteils kann eine Dünnschicht als Teil einer Dünnschichtstruktur mit einer Anzahl von weiteren Dünnschichten realisiert sein. Vorzugsweise ist die Dünnschichtstruktur zusammen mit der Substratfolie plastisch verformt.

So lassen sich mit entsprechender Kontaktierung beispielsweise Leiterbahnen, Display-Strukturen, Antennen-Strukturen im Rahmen einer elektrischen Anwendung darstellen. Grundsätzlich ist gemäß dieser Weiterbildung die Mikrostruktur als elektrisches Funktionsmittel vorgesehen, bei dem die Dünnschicht oder die Dünnschichtstruktur elektrisch leitfähig oder als Anordnung von abwechselnd elektrisch leitfähigen und elektrisch isolierenden Dünnschichten dargestellt ist. Vorzugsweise ist die gesamte Anordnung durch plastische Verformung zusammen mit der Substratfolie entstanden. Zur Darstellung von elektrisch aktiven Funktionsmitteln kann auch eine weitere Prozessierung und/oder Darstellung der Dünnschicht und/oder Struktur mit halbleitenden Materialien vorteilhaft sein und nach dem plastischen Verformen durchgeführt werden.

Entsprechend führt die Erfindung auch auf eine oder mehrere Verwendungen gemäß den unabhängigen Verwendungsansprüchen.

Hinsichtlich des Verfahrens hat es sich als besonders vorteilhaft erwiesen, dass sich eine Dünnschicht als Teil einer Dünnschichtstruktur herstellen lässt, welche eine Anzahl von weiteren Dünnschichten aufweist. Je nach Komplexität der darzustellenden funktionalen Mikrostruktur wird die Dünnschichtstruktur zusammen mit der Substratfolie plastisch verformt, wobei die weiteren Dünnschichten dünner als die Dünnschicht ist. Letzteres hat den Vorteil, dass die weiteren Dünnschichten nicht notwendigerweise die gleiche Sprödität wie die erste Dünnschicht aufweisen müssen gleichwohl aufgrund ihrer geringeren Dicke mit der spröden ersten Dünnschicht beim plastischen Verformen der Substratfolie reißen.

In einer dazu alternativen Vorgehensweise kann - wie oben angedeutet - die Substratfolie auch zunächst mit der vergleichsweise spröden Dünnschicht plastisch verformt werden und anschließend kann durch weitere Prozessierung, beispielsweise durch Aufbringen von fluiden Substanzen od.dgl. oder Aufdrucken od.dgl. eine weitere Strukturierung stattfinden. Als bevorzugtes Beschichtungsverfahren eignet sich beispielsweise ein Vakuumbeschichtungsverfahren oder andere aus der Halbleitertechnologie bekannte Prozessierverfahren wie Sputtern, CVD od. dgl. Für die plastische Verformung hat sich insbesondere ein uni- oder bidirektionales Reckverfahren als besonders geeignet erwiesen.

Ausführungsbeispiele der Erfindung werden nun nachfolgend anhand der Zeichnung beschrieben. Diese soll die Ausführungsbeispiele nicht notwendigerweise maßstäblich darstellen, vielmehr ist die Zeichnung, wo zur Erläuterung dienlich, in schematisierter und/oder leicht verzerrter Form ausgeführt. Im Hinblick auf Ergänzungen der aus der Zeichnung unmittelbar erkennbaren Lehren wird auf den einschlägigen Stand der Technik verwiesen. Dabei ist zu berücksichtigen, dass vielfältige Modifikationen und Änderungen betreffend die Form und das Detail einer Ausführungsform vorgenommen werden können, ohne von der allgemeinen Idee der Erfindung abzuweichen. Die in der Beschreibung, in der Zeichnung sowie in den Ansprüchen offenbarten Merkmale der Erfindung können sowohl einzeln als auch in beliebiger Kombination für die Weiterbildung der Erfindung wesentlich sein. Zudem fallen in den Rahmen der Erfindung alle Kombinationen aus zumindest zwei der in der Beschreibung, der Zeichnung und/oder den Ansprüchen offenbarten Merkmale. Die allgemeine Idee der Erfindung ist nicht beschränkt auf die exakte Form oder das Detail der im folgenden gezeigten und beschriebenen bevorzugten Ausführungsform oder beschränkt auf einen Gegenstand, der eingeschränkt wäre im Vergleich zu dem in den Ansprüchen beanspruchten Gegenstand. Bei angegebenen Bemessungsbereichen sollen auch innerhalb der genannten Grenzen liegende Werte als Grenzwerte offenbart und beliebig einsetzbar und beanspruchbar sein.

Im Einzelnen zeigt die Zeichnung in:
- Fig. 1:: im oberen Teil eine flexible flächige Struktur, bei welcher als Funktionsmittel dienende Mikrostrukturen zur Bildung von elektrisch leitenden Bahnen durch unidirektionales Recken ausgelegt sind und deren genaue Ausbildung im unteren Teil vergrößert dargestellt ist;
- Fig. 2:: eine schematische Darstellung eines Flachbandkabels unter Verwendung einer in Fig. 1 dargestellten flexiblen flächigen Struktur;
- Fig. 3:: eine schematisch darstellte Display-Fläche unter Verwendung von zwei flexiblen flächigen Strukturen der Fig. 1, die unter 90°-Orientierung und unter Dazwischenschaltung eines Display-Materials aufeinander aufgebracht sind - im oberen Teil ist die untere flexible flächige Struktur gezeigt;
- Fig. 4:: eine schematisch dargestellte Draufsicht auf eine vorteilhafte Verwendung einer in Fig. 1 gezeigten flexiblen flächigen Struktur zur Bildung von Source- und Drain-Anordnung für eine weitere Transistorprozessierung;
- Fig. 5:: eine schematische Darstellung im Schnitt für eine flexible flächige Struktur, hier zur Darstellung einer Displayfläche, nach weiteren Prozessierschritten;
- Fig.6:: eine flexible flächige Struktur, welche - in Abwandlung der in Fig. 1 gezeigten flexiblen flächigen Struktur - zur Bildung von elektrisch leitenden Inseln bidirektional gereckt ist;
- Fig. 7:: eine Demonstration von richtungsorientierten Benetzungseigenschaften für die in Fig. 6 gezeigte flexible flächige Struktur.

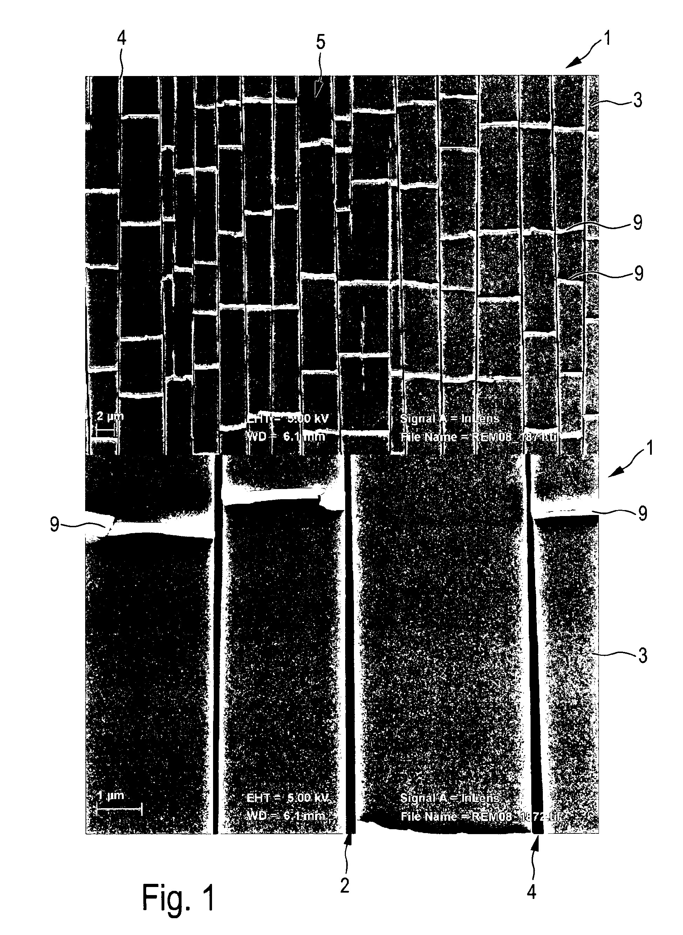

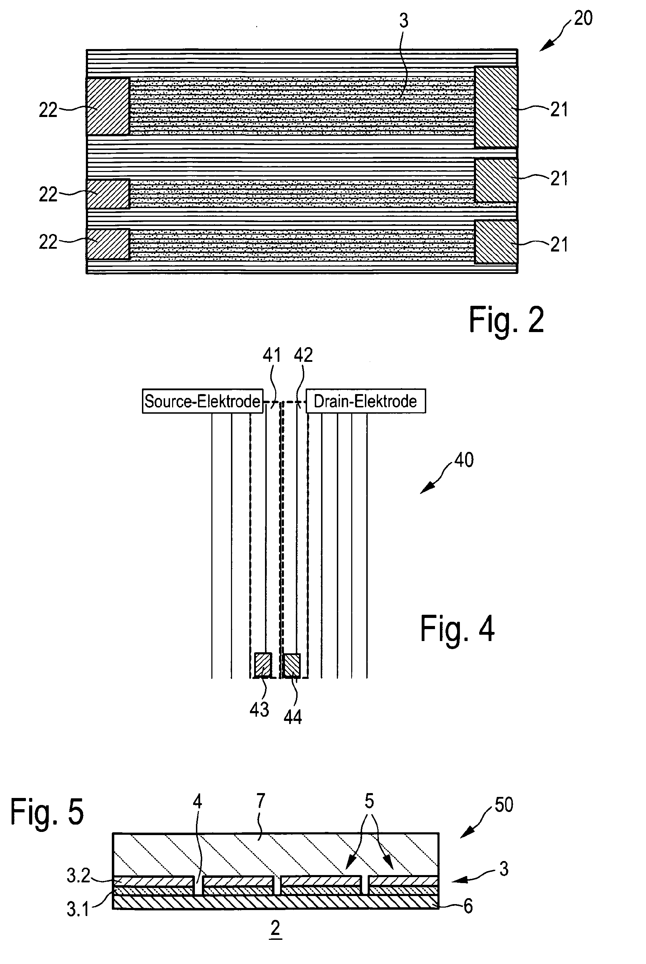

Fig. 1 zeigt eine flexible flächige Struktur 1 - im oberen Teil in einem breiten Ausschnitt und im unteren Teil in einer vergrößerten Darstellung, jeweils mit Maßstabsangabe im µm-Bereich. Die Struktur 1 wird gebildet durch eine plastisch verformte, vorliegend unidirektional gereckte, Substratfolie aus einem aromatischen Polyester, vorliegend PET. Auf der Substratfolie 2 ist eine Dünnschichtstruktur, vorliegend aus zwei Dünnschichten, nämlich einer SiOₓ und einer darauf befindlichen leitenden Metallschicht, aufgebracht. Die Substratfolie 2 und die Dünnschichtstruktur 3 sind zusammen unidirektional gereckt. Aufgrund der geringeren Elastizität des isolierenden Oxids, hier SiOₓ, im Vergleich zum PET-Material der Substratfolie 2 und aufgrund der Tatsache, dass die leitende Metallschicht der Dünnschichtstruktur 3 eine geringere Sprödigkeit und ggf. auch geringere Dicke aufweist als die isolierende SiOₓ-Schicht der Dünnschichtstruktur 3, reißt die Dünnschichtstruktur 3 an einer Vielzahl von vergleichsweise regelmäßig beabstandeten Stellen zur Bildung von Unterbrechungen 4, an welchen die Substratfolie 2 erkennbar ist. Auf diese Weise werden Mikrostrukturen 5, vorliegend in Form von Leiterbahnen, durch die unidirektional ausgerichteten und begrenzenden Unterbrechungen 4 gebildet. Praktisch entstehen eine Vielzahl von gegen die Substratfolie isolierten Metallstreifen, welche durch sehr feine Risse getrennt sind. Im Fall einer 100nm SiOₓ-Schicht als Dünnschicht im Rahmen der Dünnschichtstruktur 3, die zusammen mit der Substratfolie 2 bei 90°C um 10% gereckt wurde, erhält man 2µm bis 100µm, insbesondere 2µm bis 10 µm, breite leitende Mikrostrukturen 5 mit einer oberen metallischen und leitenden Dünnschicht und einer darunter liegenden isolierenden oxidischen Dünnschicht aus SiOₓ, wobei die Breite einer Unterbrechung 4 im Bereich von 200 bis 300nm liegt. Es hat sich gezeigt, dass die Breite der leitenden Mikrostrukturen 5 u.a. über die Haftung der SiOₓ-Schicht, insbesondere auf der Substratfolie, im Wesentlichen eingestellt werden kann. So ist es z.B. möglich, Vorbehandlungen der Schichten vorzusehen (z.B. Plasmabehandlung) und/oder Aufdampfparameter zu variieren. Zwar sind die Breiten der leitenden Mikrostrukturen 5 nicht exakt gleich und ebenso ist auch die Breite der die Risse bildenden Unterbrechungen 4 nicht gleich. Es ergibt sich aber eine im Wesentlichen unidirektional ausgerichtete anisotrope leitende Struktur, die sich für Anwendungen, wie sie in Fig. 2 bis Fig. 5 oder Fig. 7 gezeigt sind, sehr gut eignet.

Zur weiteren Auslegung kann man davon ausgehen, dass im Falle einer z.B. 100mm langen Substratfolie 2, welche um 10% - d. h. auf 110mm - gereckt wird, alle 4µm eine Unterbrechung 4 in Form eines Risses ausgebildet wird. Das heißt, man erhält bei diesem Beispiel regelmäßig in etwa 25000 Risse. Eine Rissbreite ist dabei im Bereich vom maximal 400nm zu erwarten für den Fall, dass man eine absolut unelastische Dünnschichtstruktur 3 annimmt. Aufgrund einstellbarer Reckparameter ist es möglich, wie im vorliegenden Ausführungsbeispiel der Fig. 1, die Rissbreite, d. h. die Breite der Unterbrechung 4, und/oder die Breite der Mikrostruktur einzustellen. Dabei hat man regelmäßig mit einer etwas geringeren Breite als die oben geschätzte für die Unterbrechung 4 zu rechnen, da man meist keine 100% plastische Verformung der Substratfolie 2 erreichen kann.

Fig. 2 zeigt schematisch ein Flachbandkabel 20 mit Kontaktierungen 21, 22 als Pads auf jeweils gegenüberliegenden Seiten mit entgegengesetzter Polarität, so dass sich eine entsprechende Spannung an eine vorbestimmte Auswahl von Dünnschichtstrukturen 3 anlegen lässt. Eine Dünnschichtstruktur 3 kann beispielsweise gemäß Fig. 1 ausgebildet sein und vorliegend als Leiterbahn, z. B. zur Übertragung von digitalen Signalen, dienen.

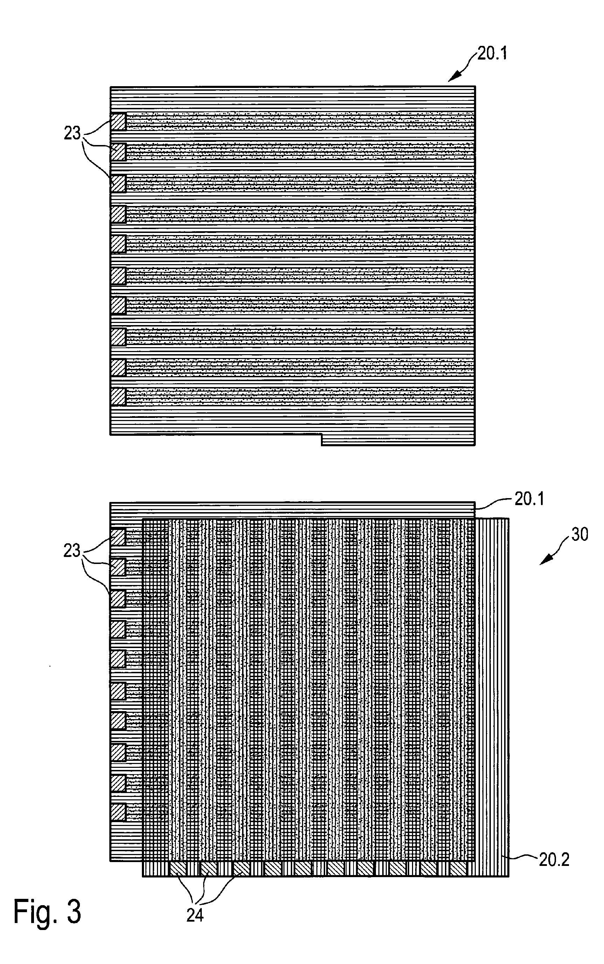

Eine solche Struktur, wie sie in Fig. 2 im Grundsatz für ein Flachbandkabel erläutert ist, kann auch zur Darstellung eines Displays 30 genutzt werden. Dazu wird über eine im oberen Teil der Fig. 3 dargestellte untere flexible flächige Struktur 20.1 mit Kontaktierungen 23 in 90°-Orientierung eine im Wesentlichen gleich ausgebildete flexible flächige Struktur 20.2 mit Kontaktierungen 24 gelegt - dies unter Zwischenschaltung eines nicht näher dargestellten aktiven Displaymaterials. Dazu hat man vorzugsweise einen durchsichtigen leitfähigen Kontakt (z. B. dünnes Metall, insbesondere Zinnoxid (ITO)) auf einer der beiden flächigen Strukturen. Über die so entstehende Displaymatrix kann man jeden einzelnen Bildpunkt (Pixel) einzeln ansteuern. Grundsätzlich ist es dazu sinnvoll, die Kontakte 23, 24 regelmäßig anzuordnen.

Insgesamt lassen sich elektrische, insbesondere aktive oder passive, Strukturen, wie sie in Fig. 2 und Fig. 3 gezeigt sind, auf einfache Weise dadurch bilden, dass eine in Fig. 1 dargestellte Dünnschichtstruktur 3 aus einer nicht-leitenden Dünnschicht und wenigstens einer weiteren leitenden Dünnschicht gebildet ist.

Fig. 4 und Fig. 5 zeigen schematisch den möglichen Aufbau einer in Fig. 1 dargestellten flexiblen flächigen Struktur 1 zur Bildung eines aufwändigeren elektrisch aktiven Bauelements. Dazu ist in Fig. 4 eine elektrisch aktive flexible flächige Struktur 40 dargestellt, bei welcher eine Dünnschichtstruktur 3 der Fig. 1 - nämlich bestehend aus einer auf einer Substratfolie 2 aufgebrachten isolierenden SiOₓ-Struktur und einer darauf aufgebrachten leitenden Metallstruktur - die Grundlage für eine Source-Elektrode 41 und eine Drain-Elektrode 42 bilden. Eine entsprechende Kontaktierung kann über eine Kontaktierung 43 als Pad für die Source-Elektrode 41 und eine Kontaktierung 44 als Pad für die Drain-Elektrode 42 vorgesehen sein. Bringt man anschließend in einer nicht näher dargestellten gleichwohl dem Fachmann bekannten Weise halbleitendes Material sowie einen Isolator und anschließend eine Gate-Elektrode auf, erhält man auf besonders einfache Weise einen so genannten Top-Gate-Transistor. Eine weitere elektrische Abgrenzung von benachbarten Transistoren kann in Richtung der als Risse erläuterten Unterbrechungen 4 z. B. durch selektives Aufdampfen durch eine Maske erfolgen. In einem "Roll-to-Roll"-Prozess ergeben sich dann getrennte Metallstreifen, welche durch eine Abschattung der Metallaufbringung, z. B. mittels einer geeigneten Maske, erfolgt.

Führt man mittels geeigneter Verfahren Paare von Kontaktierungen 43, 44 an die Metallstreifen mit einem Abstand und einer Breite im Bereich des mittleren Abstandes der Unterbrechungen 4, so kann man damit zwei leitfähige Linien kontaktieren, welche genau um die Rissbreite - also beispielsweise 200nm - voneinander entfernt sind. Geeignete Verfahren sind beispielsweise Drucken, Mikrospritzen, Fotolithographie oder Laserablation. Wenn man nun einen Halbleiter über diese Struktur beschichtet, so erhält man damit den oben erläuterten schmalen Kanal für einen Feldeffekttransistor, welcher über eine darüber liegende isolierte Top-Gate-Elektrodenschicht angesteuert werden kann.

Eine weitere Möglichkeit einer Basisstruktur für elektrische Bauelemente ist in Fig. 5 als weiteres Beispiel einer flexiblen flächigen elektrisch aktiven Struktur 50 gezeigt. Vorliegend ist die Substratfolie 2 mit einer leitenden, z. B. metallischen, Rückkontaktschicht 6 beschichtet. Auf dieser wiederum ist eine Dünnschichtstruktur 3, wie anhand von Fig. 1 erläutert, mit einer isolierenden SiOₓ-Schicht 3.1 und einer leitenden metallischen Dünnschicht 3.2 aufgebracht. Beispielsweise kann die Aufbringung durch ein Vakuumaufdampfverfahren oder dergleichen übliches Depositionsverfahren erfolgen. Die in Fig. 5 gezeigte flexible flächige Struktur 50 ist bereits in einem gereckten Zustand gezeigt, so dass die Unterbrechungen 4 zwischen den Mikrostrukturen 5 erkennbar sind, welche letztere durch die erläuterten Dünnschichtstrukturen 3 gebildet sind. Vorliegend ist dieser Zustand der Struktur 50 mit einer elektrisch aktiven Schicht 7, vorliegend leitende Druckfarbe, übergossen. Die oberste elektrisch aktive Schicht 7 dringt in die Unterbrechungen 4 ein. Damit erhält man eine elektrisch ansteuerbare, z. B. leuchtaktive Schicht 7, welche durch die metallisch leitende Dünnschicht 3.2 und die leitende Rückkontaktschicht 6 - welche evtl. beim Recken der Substratfolie 2 mitreißt, aber nicht mitreißen muss - angesteuert werden kann. Das heißt, man hat in vergleichsweise kurzem Abstand, welcher durch die Dicke der isolierenden Oxiddünnschicht 3.1 ausgemacht ist, zwei elektrisch leitende, aber voneinander isolierte Kontaktschichten 3.2 und 6, welche unmittelbar in Kontakt mit der aktiven Schicht 7 stehen. Im vorliegenden Fall ist die Schicht 7 als elektrisch ansteuerbare leuchtaktive Schicht ausgebildet, beispielsweise ein Leuchtpolymer. Wenn nun, wie im vorliegenden Fall, eine oder beide Metallkontaktschichten 3.2, 6 semitransparent sind, beispielsweise indem sie besonders dünn ausgebildet sind, kann man das zwischen den Metallkontakten erzeugte Licht flächig auskoppeln. Die in Fig. 5 dargestellte flexible flächige Struktur 50 eignet also als besonders einfache und kostengünstig prozessierbare Display-Struktur. Besonders vorteilhaft ist eine Verwendung bei Leuchten, insbesondere Flächenleuchten wie OLEDs od.dgl.

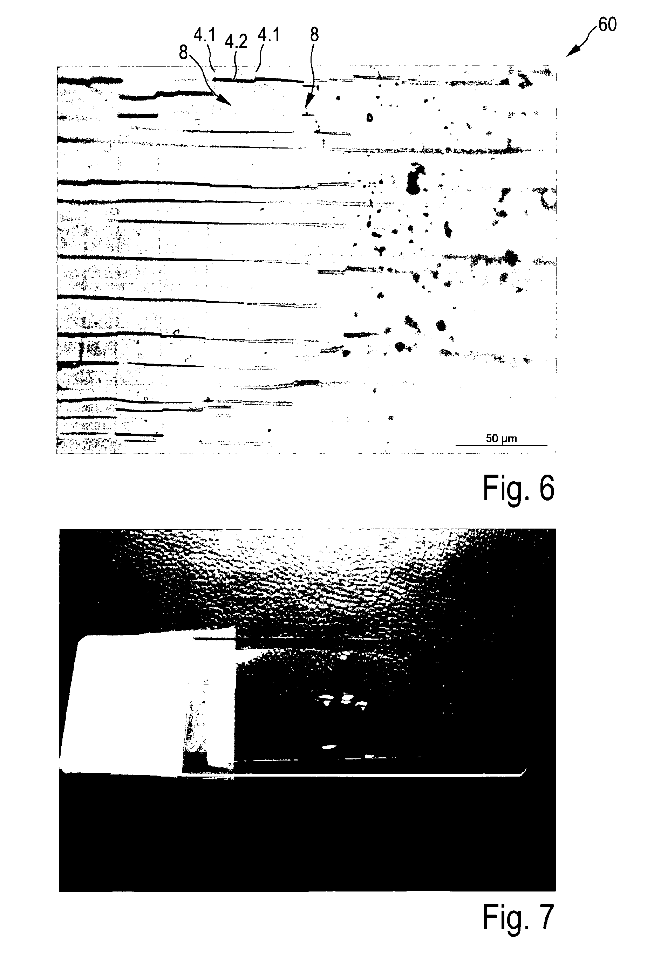

Fig. 6 zeigt eine andere flexible flächige Struktur 60 in Abwandlung der in Fig. 1 dargestellten flexiblen flächigen Struktur 1. Die flexible flächige Struktur 60 ist beidseitig, d. h. bidirektional, gereckt. Damit ergeben sich kreuzende Linien von Unterbrechungen 4.1, 4.2, die zur Ausbildung von rechteckigen durch die Unterbrechungen 4.1, 4.2 begrenzten inselartigen Mikrostrukturen 8 führen. Der Schichtaufbau der Mikrostrukturen 8 kann ganz analog eines Aufbaus einer Dünnschichtstruktur 3, wie sie beispielhaft anhand der Fig. 1 bis Fig. 5 erläutert wurde, erfolgen. Im Falle einer Dünnschichtstruktur 3 mit einer isolierenden und einer leitenden Schicht auf der isolierenden Schicht ergeben sich nach dem bidirektionalen Recken elektrisch leitfähige Inseln, welche beispielsweise genutzt werden können, um hochleitende elektrische Systeme mit niedrigleitenden Verbindungen herzustellen.

Ein Beispiel dafür sind Antennen. Da die Inseln elektrisch nicht verbunden sind, absorbieren und/oder reflektieren sie in einem großen Frequenzbereich keine Funkwellen. Die Metallschichten leiten relativ gut - dies im Vergleich z. B. zu einer Silberleitfarbe. Da die Metallschicht als Dünnschicht innerhalb einer Dünnschichtstruktur 3 viel größer ist als der isolierende Spalt in Form der zuvor erläuterten Unterbrechungen 4.1, 4.2 (etwa 10- oder mehrfach größer) kann man mit relativ schlecht leitender Farbe die isolierten Stellen verbinden. Der gesamte Widerstand wird relativ klein bleiben. Somit kann man mit Aufdruck einer Antennenstruktur auf so eine gereckte Folie mit relativ schlecht leitender Farbe relativ gute Antennen herstellen.

Eine zweite Anwendungsmöglichkeit solcher flexiblen flächigen Strukturen 60, wie sie in Fig. 6 gezeigt sind, kann in Form von so genannten Susceptoren, d. h. Mikrowellenabsorbern, erfolgen. Diese werden genutzt, um z. B. Lebensmittel in der Mikrowelle zu erhitzen. Diese fein strukturierten Unterbrechungen 4.1, 4.2 zur Bildung von rechteckigen Mikrostrukturen 8 werden einen Teil der Mikrowellenstrahlung durchlassen, aber auch einen Teil absorbieren und in Wärme umwandeln.

Eine weitere Anwendung der in Fig. 6 dargestellten flexiblen flächigen Struktur 60 ist in Fig. 7 gezeigt. Da SiOₓ hydrophil ist, ergibt sich aus einer - vorliegend mit SiOₓ-Dünnschicht beschichteten Substratfolie - gereckten Struktur ein interessantes Material für Flüssigkeiten, die Wasser als Lösungsmittel enthalten. Wassertropfen, wie sie in Fig. 7 dargestellt sind, laufen zwar auseinander, ergeben aber statt kreisförmiger Umrandungen nun stäbchenförmige Konturen. Unter Ausnutzung dieses Effekts schlägt das Konzept der Erfindung die Verwendung im Rahmen einer Druckstruktur mit höherer Auflösung vor.

Zurückkommend auf die in Fig. 1 dargestellte flexible flächige Struktur hat sich gezeigt, dass sich im Bereich der aufgebrachten Dünnschichtstruktur 3 - sei es eine mit isolierender (SiOₓ) und/oder leitender (Metall) Dünnschicht gebildete Dünnschichtstruktur 3 oder eine lediglich aus einer einzigen Dünnschicht gebildete Dünnschichtstruktur (Metallisolator, Keramik od.dgl.) - Aufstauchungen ergeben, die in Fig. 1 mit dem Bezugszeichen 9 gekennzeichnet sind. Es hat sich gezeigt, dass Aufstauchungen 9 dieser Art nicht gleichmäßig, sondern vielmehr zufällig und nicht vorhersagbar auftreten hinsichtlich ihrer örtlichen Anordnung. Eine in Fig. 1 dargestellte Struktur kann somit unter Nutzung der zufällig auftretenden Aufstauchung 9 zur eindeutigen Identifizierung, z. B. im Rahmen eines Sicherheitsmerkmals od. dgl. genutzt werden. Dafür kann man ein optisches Bild der Struktur speichern und sich die Position auf der Folie speichern. Eine Wiederholung dieser Positionsanordnung, welche auf die Struktur passt, ist praktisch nicht möglich. Es hat sich gezeigt, dass eine solche flexible leitfähige Struktur besonders einfach im Rahmen einer auf einer Substratfolie aufgebrachten einzigen Dünnschicht, beispielsweise aus SiOₓ oder einem anderen Material, welche eine geringere Elastizität als die Substratfolie aufweist, gebildet ist.

Die Erfindung betrifft eine flexible flächige Struktur 1, 60 aufweisend eine plastisch verformte, insbesondere gereckte, Substratfolie 2 und wenigstens eine Dünnschicht 3.1, 3.2 auf der Substratfolie 2, welche eine geringere Elastizität aufweist als die Substratfolie 2 und in Flächenrichtung begrenzte Mikrostrukturen 5, 8 bildet, wobei zur Erzeugung von die Mikrostrukturen 5, 8 begrenzenden Unterbrechungen 4, 4.1, 4.2 die wenigstens eine Dünnschicht 3.1, 3.2 zusammen mit der Substratfolie 2 plastisch verformt ist. Erfindungsgemäß ist vorgesehen, dass die Mikrostrukturen 5, 8 als Funktionsmittel dienen. In einer besonders bevorzugten Weiterbildung dienen die Mikrostrukturen 5, 8 als elektrisches Funktionsmittel. In einer anderen bevorzugten Weiterbildung dienen die Mikrostrukturen 5, 8 als Druckmittel.

### Bezugszeichenliste

- 1: Struktur
- 2: Substratfolie
- 3: Dünnschichtstruktur
- 3.1: SiOₓ-Schicht
- 3.2: Dünnschicht
- 4: Unterbrechungen
- 4.1: Unterbrechungen
- 4.2: Unterbrechungen
- 5: Mikrostrukturen
- 6: Rückkontaktschicht
- 7: Schicht
- 8: Mikrostrukturen
- 9: Aufstauchungen

- 20: Flachbandkabel
- 20.1: untere flexible Struktur
- 20.2: gleich ausgebildete flächige Struktur
- 21: Kontaktierungen
- 22: Kontaktierungen
- 23: Kontaktierungen
- 24: Kontaktierungen

- 40: elektrisch aktive Struktur
- 41: Source-Elektrode
- 42: Drain-Elektrode
- 43: Kontaktierungen
- 44: Kontaktierungen

- 50: Struktur

- 60: Struktur

## Patentansprüche

1. Flexible flächige Struktur (1, 60) aufweisend eine plastisch verformte, insbesondere gereckte, Substratfolie (2) und wenigstens eine Dünnschicht (3.1, 3.2) auf der Substratfolie (2), welche Dünnschicht, insbesondere eine geringere Elastizität aufweist als die Substratfolie (2), und, in Flächenrichtung begrenzte Mikrostrukturen (5, 8) bildet, wobei zur Erzeugung von die Mikrostrukturen (5, 8) begrenzenden Unterbrechungen (4, 4.1, 4.2)) die wenigstens eine Dünnschicht (3.1, 3.2) zusammen mit der Substratfolie (2) plastisch verformt ist, und wobei die Mikrostrukturen (5, 8) als Funktionsmittel dienen.

2. Flexible flächige Struktur (1, 60) nach Anspruch 1,
**dadurch gekennzeichnet, dass**
die Mikrostrukturen (5) nur unidirektional durch Unterbrechungen (4) begrenzt sind, insbesondere durch unidirektionales Recken der Substratfolie (2) mit der wenigstens einen Dünnschicht (3.1, 3.2).

3. Flexible flächige Struktur (1, 60) nach Anspruch 1,
**dadurch gekennzeichnet, dass**
die Mikrostrukturen (8) bidirektional durch Unterbrechungen (4.1, 4.2) begrenzt sind, insbesondere durch bidirektionales Recken der Substratfolie (2) mit der wenigstens einen Dünnschicht (3.1, 3.2).

4. Flexible flächige Struktur (1, 60) nach einem der Ansprüche 1 bis 3,
**dadurch gekennzeichnet, dass**
die Substratfolie (2) aus organischem Material ist, insbesondere einem Kunststoff, insbesondere einem aromatischen Polyester, wie PET od. dgl.

5. Flexible flächige Struktur (1, 60) nach einem der Ansprüche 1 bis 4,
**dadurch gekennzeichnet, dass**
die Dünnschicht (3.1, 3.2) aus anorganischem Material, wie einem Oxid, insbesondere SiOₓ, einem Metall, einer Keramik od. dgl. ist.

6. Flexible flächige Struktur (1, 60) nach einem der Ansprüche 1 bis 5,
**dadurch gekennzeichnet, dass**
die wenigstens eine Dünnschicht (3.1, 3.2) Teil einer Dünnschichtstruktur (3) ist, welche eine Anzahl von weiteren Dünnschichten (3.2) aufweist.

7. Flexible flächige Struktur (1, 60) nach einem der Ansprüche 1 bis 6,
**dadurch gekennzeichnet, dass**
die Mikrostrukturen (5, 8) als elektrisches, insbesondere aktives oder passives, Funktionsmittel dienen.

8. Flexible flächige Struktur (1, 60) nach einem der Ansprüche 1 bis 7,
**dadurch gekennzeichnet, dass**
eine Dünnschicht (3.1, 3.2) Teil einer Dünnschichtstruktur (3) ist, welche eine Anzahl von weiteren Dünnschichten (3.2) aufweist, wobei die Dünnschichtstruktur (3) zusammen mit der Substratfolie (2) plastisch verformt ist.

9. Flexible flächige Struktur (1, 60) nach einem der Ansprüche 1 bis 8,
**dadurch gekennzeichnet, dass**
eine Dünnschicht (3.1) in Form eines elektrischen Isolators gebildet ist und eine Anzahl von weiteren Dünnschichten (3.2) als leitende und/oder halbleitende Dünnschichten gebildet ist.

10. Flexible flächige Struktur (1, 60) nach einem der Ansprüche 1 bis 9,
**dadurch gekennzeichnet, dass**
eine Dünnschichtstruktur (3) aus der nicht-leitenden Dünnschicht (3.1) und wenigstens einer weiteren leitenden Dünnschicht (3.2) gebildet ist, insbesondere zur Bildung eines Flachbandkabels (20) oder einer Anzeige (30) aus der oder einer Anzahl von flexiblen flächigen Strukturen (20.1, 20.2).

11. Flexible flächige Struktur (1, 60) nach einem der Ansprüche 1 bis 9,
**dadurch gekennzeichnet, dass**
eine Dünnschicht (3.1), insbesondere in Form eines elektrischen Isolators, Teil einer Dünnschichtstruktur (3) ist, welche eine Anzahl von weiteren Dünnschichten (3.2) aufweist, insbesondere einer M(etall)-S(emiconductor)-M(etall)-Dünnschicht-Abfolge, insbesondere zur Bildung eines Halbleiterbauelementes (40, 50).

12. Flexible flächige Struktur (1, 60) nach einem der Ansprüche 1 bis 10,
**dadurch gekennzeichnet, dass**
das Halbleiterbauelement ein Transistor (40) ist, insbesondere mit der Substratfolie (2) als Substrat und einer Dünnschichtstruktur (3) mit einer ersten Dünnschicht (3.1) als SiOₓ-Material oder einem anderen Oxid und mit einer zweiten Dünnschicht (3.2) aus Metall oder einem anderen Leiter zur Bildung einer Source (41) und einer Drain (42), wobei die Dünnschichtstruktur (3) zusammen mit der Substratfolie (2) plastisch verformt ist.

13. Flexible flächige Struktur (1, 60) nach Anspruch 12,
**dadurch gekennzeichnet, dass**
das Halbleiterbauelement ein Top-Gate-Transistor (40) ist, wobei ein Halbleitermaterial, ein isolierendes Material und ein leitendes Material zur Bildung einer Gate-Elektrode aufgebracht ist.

14. Flexible flächige Struktur (1, 60) nach einem der Ansprüche 1 bis 13,
**dadurch gekennzeichnet, dass**
eine leitfähige Schicht aus Metall oder ITO oder einer keramischen Schicht mit elektrisch leitfähigen Partikeln gebildet ist.

15. Flexible flächige Struktur (1, 60) nach einem der Ansprüche 1 bis 6,
**dadurch gekennzeichnet, dass**
die Mikrostrukturen (5, 8) als Druckmittel dienen.

16. Flexible flächige Struktur (1, 60) nach einem der Ansprüche 1 bis 6,
**dadurch gekennzeichnet, dass**
das Druckmittel zum Einsatz beim Tintendruck ausgebildet ist.

17. Flexible flächige Struktur (1, 60) nach einem der Ansprüche 1 bis 6,
**dadurch gekennzeichnet, dass**
das Druckmittel zum Einsatz als Sicherheitsmittel ausgebildet ist, insbesondere zufällige Stauchungen (9) in der Dünnschicht (3.1, 3.2) als Sicherheitsmittel dienen.

18. Verfahren zur Herstellung einer flexiblen flächigen Struktur (1, 60) aufweisend eine plastisch verformte, insbesondere gereckte, Substratfolie (2) und wenigstens eine Dünnschicht (3.1, 3.2) auf der Substratfolie (2), welche Dünnschicht, insbesondere eine geringere Elastizität aufweist als die Substratfolie (2) und, in Flächenrichtung begrenzte Mikrostrukturen (5, 8) bildet, nach einem der Ansprüche 1 bis 17, wobei
- zur Erzeugung von die Mikrostrukturen (5, 8) begrenzenden Unterbrechungen (4, 4.1, 4.2) die wenigstens eine Dünnschicht (3.1, 3.2) zusammen mit der Substratfolie (2) plastisch verformt wird, wobei die Mikrostrukturen (5, 8) als Funktionsmittel ausgelegt werden.

19. Verfahren nach Anspruch 18,
**dadurch gekennzeichnet, dass** eine Dünnschicht (3.1, 3.2) Teil einer Dünnschichtstruktur (3) ist, welche eine Anzahl von weiteren Dünnschichten (3.2) aufweist, wobei die Dünnschichtstruktur (3) zusammen mit der Substratfolie (2) plastisch verformt wird, wobei die weiteren Dünnschichten (3.2) dünner als die erste Dünnschicht (3.1) sind.

20. Verfahren nach Anspruch 18 oder 19,
**dadurch gekennzeichnet, dass**
nach dem plastischen Verformen weitere Dünnschichten 3.2) aufgebracht werden, insbesondere als fluide Substanz od. dgl., insbesondere durch aufdrucken od. dgl.

21. Verfahren nach einem der Ansprüche 18 bis 20,
**dadurch gekennzeichnet, dass**
uni- oder bidirektional gereckt wird.

22. Verfahren nach Anspruch 18,
**dadurch gekennzeichnet, dass**
eine Dünnschicht (3.1, 3.2) oder die Dünnschichtstruktur (3) mittels VakuumBeschichtungsverfahren aufgebracht wird.

23. Verwendung einer oder mehrerer der flexiblen flächigen Strukturen (1, 60)
nach einem der vorhergehenden Ansprüche im Rahmen einer, insbesondere aktiven oder passiven, Elektronikanwendung.

24. Verwendung nach Anspruch 23,
**dadurch gekennzeichnet, dass**
die flexible flächige Struktur (1, 60) als unidirektionale Struktur (1, 20) mit einer unidirektionalen Kontaktierung (21, 22), insbesondere in einer Ebene, im Rahmen eines Flachbandes funktioniert.

25. Verwendung nach Anspruch 23,
**dadurch gekennzeichnet, dass**
die flexible flächige Struktur (1, 60), insbesondere teilweise transparent, als bidirektionale Struktur (1, 30, 60) mit einer bidirektionalen Kontaktierung (23, 24), insbesondere in zwei Ebenen, im Rahmen eines Displays funktioniert, insbesondere mit zwischen zwei Ebenen angeordnetem Display-Material.

26. Verwendung nach Anspruch 23,
**dadurch gekennzeichnet, dass** die flexible flächige Struktur (1, 60) im Rahmen einer Antenne oder eines Antennen-Arrays funktioniert.

27. Verwendung einer oder mehrerer der flexiblen flächigen Strukturen (1, 60),
nach einem der vorhergehenden Ansprüche im Rahmen einer Druckstruktur, insbesondere einer Druckmatrize od. dgl.
